# EUROPEAN PATENT APPLICATION

(11) **EP 1 594 226 A1**
(43) Date of publication of application: **09.11.2005**
(21) Application number: 05009916.7
(22) Date of filing: 06.05.2005
(51) Int. Cl.: H03J 3/32, H03J 3/18, H03J 5/24

(54) **Tuning frequency correction circuit and terrestrial digital broadcasting receiving tuner having the same**

(30) Priority: 07.05.2004 JP 2004138851
(71) Applicant: ALPS ELECTRIC CO., LTD., Tokyo 145-8501 (JP)
(72) Inventor: Suzuki, Takeo, Ota-ku Tokyo (JP)
(74) Representative: Klunker . Schmitt-Nilson . Hirsch

(57) **Abstract**

A tuning frequency correction circuit includes a circuit board provided with an inductor composed of a printed conductor, a capacitive unit provided on the circuit board and constituting a parallel tuning circuit together with the inductor, and an integrated circuit which is provided with amplifying transistors, mixing transistors, or oscillating transistors connected to the parallel tuning circuit and which is mounted on the circuit board. In the tuning frequency correction circuit, the integrated circuit includes one or more capacitance adding units which are connected in parallel to the parallel tuning circuit, each of the capacitance adding units being composed of a switching element and a capacitive element connected in series to the switching element, and a variation of a tuning frequency of the parallel tuning circuit is corrected by turning on or off the switching elements.

## Description

### BACKGROUND OF THE INVENTION

### 1. Field of the Invention

The present invention relates to a tuning frequency correction circuit for correcting the variation of a tuning frequency of a tuning circuit which is connected to an amplifier, a mixer, or an oscillator used for a television tuner, and to a terrestrial digital broadcasting receiving tuner having the tuning frequency correction circuit.

### 2. Description of the Related Art

FIG. 4 shows the configuration of a conventional television tuner. In FIG. 4, a television signal of a receiving channel, among television signals input to an antenna tuning circuit 52 through an input terminal 51, is selected by the antenna tuning circuit 52 and is then input to a high-frequency amplifier 53. Then, the television signal is amplified by the high-frequency amplifier 53, and the amplified signal is given steep selectivity characteristics by an interstage tuning circuit 54. Subsequently, the signal is input to a mixer 55. A local oscillating signal output from a local oscillator 56 is input to the mixer 55, and the television signal of the receiving channel is converted into an intermediate frequency signal to be output to an output terminal 58 through an intermediate frequency tuning circuit 57.

The antenna tuning circuit 52 includes a tuning coil 52a and a varactor diode 52b connected in parallel to each other. A tuning frequency is varied by a tuning voltage applied to the varactor diode 52b, and thus the television signal of the receiving channel is selected.

The interstage tuning circuit 54 includes a double tuning circuit composed of two single tuning circuits having the same structure. One single tuning circuit has a tuning coil 54a and a varactor diode 54b connected in parallel to each other, and the tuning frequency is varied by a tuning voltage applied to the varactor diode 54b.

In addition, the local oscillator 56 includes a tuning coil 56a and a varactor diode 56b connected in parallel to each other, and the frequency of the local oscillating signal (local oscillating frequency) is varied by a tuning voltage applied to the varactor diode 56b.

In the varactor diode 52b of the antenna tuning circuit 52, the varactor diode 54b of the interstage tuning circuit 54 and the varactor diode 56b of the local oscillator 56, the respective anodes are grounded, and the respective cathodes are applied with a common tuning voltage VT.

Further, although not shown, the tuning coil 52a of the antenna tuning circuit 52, the tuning coil 54a of the interstage tuning circuit 54 and the tuning coil 56a of the local oscillator 56 are switched such that inductances thereof have different values when the television tuner receives a high-band television signal and when it receives a low-band television signal. That is, each of the tuning circuits is a band-switching-type tuning circuit (for example, see Japanese Unexamined Patent Application Publication No. 11-220362 (FIG. 7)).

In a conventional tuning circuit used for a television tuner, although a tuning coil is mechanically processed, its inductance becomes non-uniform even by a little deformation. Therefore, an initial setting of the tuning frequency has been performed by the adjustment (homing) of the tuning coil. However, in a case where a printed conductor formed on a circuit board is used instead of the tuning coil, the initial setting work on the tuning frequency has been troublesome since the printed conductor has to be trimmed to adjust the inductance.

### SUMMARY OF THE INVENTION

The present invention is designed to solve the above-mentioned problem, and it is an object of the present invention to provide a tuning frequency correction circuit capable of easily correcting the variation of a tuning frequency and a terrestrial digital broadcasting receiving tuner using the tuning frequency correction circuit.

In order to achieve the above object, according to an aspect of the invention, there is provided a tuning frequency correction circuit including a circuit board provided with an inductor composed of a printed conductor; a capacitive unit provided on the circuit board and constituting a parallel tuning circuit together with the inductor; and an integrated circuit which is provided with amplifying transistors, mixing transistors, or oscillating transistors connected to the parallel tuning circuit and which is mounted on the circuit board. In the frequency correction circuit, the integrated circuit includes one or more capacitance adding units which are connected in parallel to the parallel tuning circuit, each capacitance adding unit being composed of a switching element and a capacitive element connected in series to the switching element. In addition, the variation of a tuning frequency of the parallel tuning circuit is corrected by turning on or off the switching elements.

Further, it is preferable that the integrated circuit further include a control circuit for controlling on or off states of the switching elements, and that data for correcting the variation of the tuning frequency of the parallel tuning circuit be input to the control circuit from the outside.

Furthermore, it is preferable that two transistors be differentially connected to each other.

Moreover, it is preferable that the capacitive unit is provided with a varactor diode to which a tuning voltage is applied, and that a tuning frequency by the parallel tuning circuit and the capacitance adding units be set to a predetermined value in a state where a predetermined voltage is applied to the varactor diode.

In addition, it is preferable that the parallel tuning circuit be connected to signal output terminals of the transistors.

Further, according to another aspect of the invention, there is provided a terrestrial digital broadcasting receiving tuner including a variable tuning amplifying circuit composed of the amplifying transistors and the above-mentioned tuning frequency correction circuit, an oscillating circuit composed of the oscillating transistors and the above-mentioned tuning frequency correction circuit, and a mixing circuit composed of the mixing transistors and the above-mentioned tuning frequency correction circuit.

### BRIEF DESCRIPTION OF THE DRAWINGS

FIG. 1 is a circuit diagram showing the configuration of a variable tuning amplifying circuit to which a tuning frequency correction circuit of the invention is applied;
FIG. 2 is a circuit diagram showing the configuration of a mixing circuit to which the tuning frequency correction circuit of the invention is applied;
FIG. 3 is a circuit diagram showing the configuration of an oscillating circuit to which the tuning frequency correction circuit of the invention is applied; and
FIG. 4 is a circuit diagram showing the configuration of a conventional television tuner.

### DESCRIPTION OF THE PREFERRED EMBODIMENT

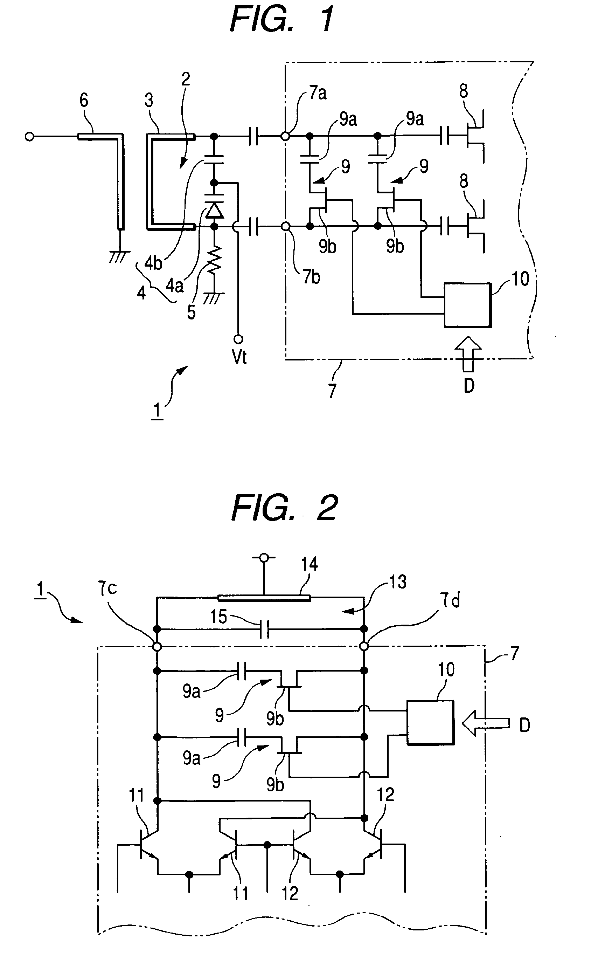

FIGS. 1 to 3 show a variable tuning amplifying circuit, a mixing circuit, and an oscillating circuit to which a tuning frequency correction circuit of the invention is applied, respectively, and each of them is suitable for a terrestrial digital broadcasting receiving tuner (including a tuner incorporated into a mobile phone) which can be used by a low-voltage source, such as a battery.

First, referring to FIG. 1, a parallel tuning circuit 2 is formed on a circuit board 1. The parallel tuning circuit 2 is composed of a tuning inductor 3 and a capacitive unit 4 connected in parallel to the tuning inductor 3, and the tuning inductor 3 is composed of a printed conductor formed on the circuit board 1. Also, the capacitive unit 4 is composed of a varactor diode 4a and a capacitor 4b connected in series to the varactor diode 4a. An anode of the varactor diode 4a is grounded through a bias resistor 5. A cathode thereof is applied with a tuning voltage for varying a tuning frequency. Further, a coupling inductor 6 coupled with the tuning inductor 3 is formed on the circuit board 1. The coupling inductor 6 is also composed of a printed conductor. In addition, one terminal thereof is input with a television signal, and the other terminal is grounded.

Further, an integrated circuit 7 for tuner is mounted on the circuit board 1. Amplifying transistors 8 are provided in the integrated circuit 7. Each of the transistors 8 is a bipolar or field effect transistor, and the transistors 8 are differentially connected to each other. Bases (or gates) thereof, serving as input terminals, are connected to terminals 7a and 7b of the integrated circuit 7, respectively. Also, the parallel tuning circuit 2 is connected to the terminals 7a and 7b. In this way, the parallel tuning circuit 2 and the transistors 8 constitute the variable tuning amplifying circuit.

Furthermore, in the integrated circuit 7, one or more capacitance adding units 9 for correcting the variation of the tuning frequency of the parallel tuning circuit 2 are formed. Each of the capacitance adding units 9 is composed of a capacitive element 9a and a switching element 9b connected in series to the capacitive element 9a, and is connected in parallel to the parallel tuning circuit 2 when the parallel tuning circuit 2 is connected to the terminals 7a and 7b. The capacitance of the capacitive element 9a is so small as to correct the tuning frequency of the parallel tuning circuit 2 a little low. Also, the switching element 9b is composed of a bipolar or field effect transistor, and is turned on by a voltage applied to its base (or gate).

Moreover, in the integrated circuit 7, a control circuit 10 for controlling the switching (on/off) of the switching element 9b is provided. Data D for correcting a tuning frequency is input from the outside of the integrated circuit 7 to the control circuit 10. In other words, the tuning frequency of each parallel tuning circuit 2 varies due to the variation of the tuning inductor 3 or the like even though the tuning frequency applied to the varactor diode 4a is constant. Therefore, the tuning frequency is checked for each parallel tuning circuit 2 in advance, and a capacitance value required to match the tuning frequency with a predetermined frequency is estimated for each parallel tuning circuit 2 in advance. Then, data is input to the control circuit 10 for turning on at least one switching element 9b for adding the capacitance value. Thereby, the switching element 9b connected to the capacitive element 9a to be added to the parallel tuning circuit 2 is turned on. As a result, the tuning frequency of each parallel tuning circuit 2 can be equally varied within a necessary frequency range with respect to the same tuning frequency.

Referring to FIG. 2, in the integrated circuit 7, (bipolar or field effect) output transistors 11 and 12 for a double-balanced mixer are provided such that they are differentially connected to each other. Collectors (or drains), serving as output terminals of the transistors 11 and 12, are connected to each other and are connected to terminals 7c and 7d. Also, a parallel tuning circuit 13 is formed on the circuit board 1. The parallel tuning circuit 13 is composed of a tuning inductor 14 and a capacitive unit 15 connected in parallel to the tuning inductor 14, and the tuning inductor 14 is composed of a printed conductor formed on the circuit board 1. The midpoint of the tuning inductor 14 is connected to a power source, and thus a voltage is applied to the collectors of the transistors 11 and 12. Also, in the integrated circuit 7, similar to FIG. 1, a capacitance adding unit 9 connected between the terminals 7c and 7d is provided. In addition, a control voltage is applied to the switching element 9b from the control circuit 10.

In FIG. 2, a tuning varactor diode is not used. Instead, the variation of the tuning frequency of the parallel tuning circuit 13 is corrected by the capacitance adding unit 9.

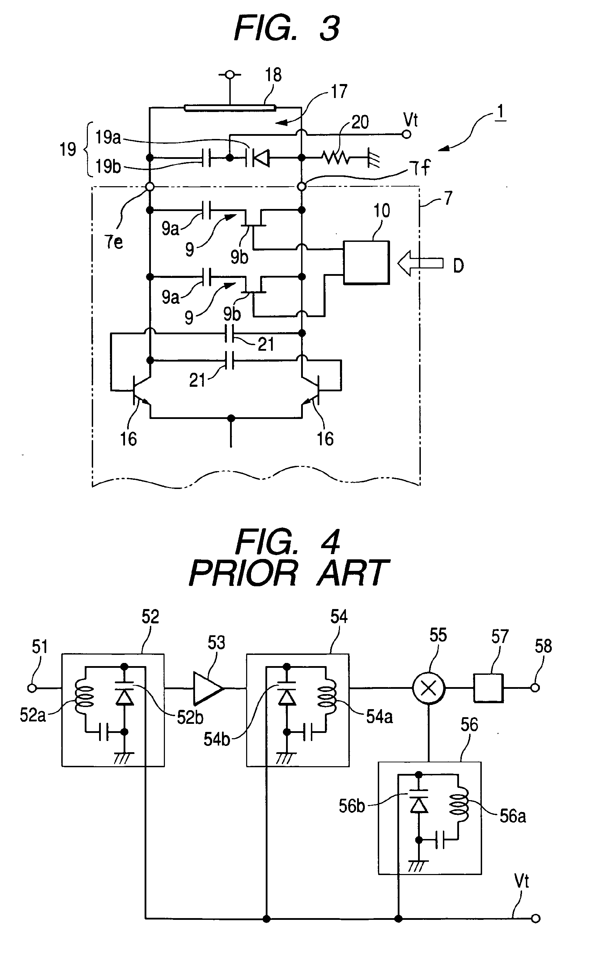

Referring to FIG. 3, in the integrated circuit 7, (bipolar or field effect) oscillating transistors 16 are formed such that they are differentially connected to each other. Collectors (or drains), serving as output terminals of the transistors 16, are connected to terminals 7e and 7f. Also, a parallel tuning circuit 17 is formed on the circuit board 1. The parallel tuning circuit 17 is composed of a tuning inductor 18 and a capacitive unit 19 connected in parallel to the tuning inductor 18, and the tuning inductor 18 is composed of a printed conductor formed on the circuit board 1. The midpoint of the tuning inductor 18 is connected to a power source, and thus a voltage is applied to the collectors of the oscillating transistors 16. Also, the capacitive unit 19 is composed of a varactor diode 19a and a capacitor 19b connected in series to the varactor diode 19a. An anode of the varactor diode 19a is grounded through a bias resistor 20. A cathode thereof is applied with a tuning voltage for varying a tuning frequency. Further, in the integrated circuit 7, similar to FIG. 1, the capacitance adding unit 9 connected between the terminals 7e and 7f is provided. Also, a control voltage is applied to the switching element 9b from the control circuit 10. Furthermore, coupling capacitors 21 for feedback are connected between the collectors and bases of the oscillating transistors 16, respectively.

In FIG. 3, similar to FIG. 1, an oscillating frequency when a tuning voltage having a predetermined value is applied to the varactor diode 19a is examined in advance, and the switching element 9b is controlled to add the capacitive element 9a for allowing the oscillation frequency equal to a predetermined value. As a result, the oscillation frequency of each parallel tuning circuit 17 can be equally varied within a necessary frequency range with respect to the same tuning frequency, so that the variation of the oscillating frequency does not occur.

In the variable tuning amplifying circuit shown in FIG. 1 and the oscillating circuit shown in FIG. 3, even though the variation of the tuning frequencies of the parallel tuning circuits 2 and 17 occur, it is corrected by the capacitance adding unit 9. Therefore, the tuning frequency or the oscillating frequency can be uniformly varied by a tuning voltage in a predetermined range. Accordingly, when the circuits shown in FIGS. 1 to 3 are employed for a terrestrial digital broadcasting receiving tuner using a battery as a power source, it is possible to widen the range of a receiving frequency to the maximum.

As described above, according to an aspect of the invention, a tuning frequency correction circuit includes a circuit board provided with an inductor composed of a printed conductor, a capacitive unit provided on the circuit board and constituting a parallel tuning circuit together with the inductor, and an integrated circuit which is provided with amplifying transistors, mixing transistors, or oscillating transistors connected to the parallel tuning circuit and which is mounted on the circuit board. In the tuning frequency correction circuit, the integrated circuit includes one or more capacitance adding units which are connected in parallel to the parallel tuning circuit, each capacitance adding unit being composed of a switching element and a capacitive element connected in series to the switching element, and the variation of a tuning frequency of the parallel tuning circuit is corrected by turning on or off the switching elements. Accordingly, although the inductance of the inductor, the internal capacitance of the transistor, or the capacitance of other elements varies, it is possible to prevent the variation of the tuning frequencies of the amplifying circuit and the mixing circuit or the oscillating frequency of the oscillating circuit.

Further, according to the aspect of the invention, in the tuning frequency correction circuit, the integrated circuit further includes a control circuit for controlling on/off states of the switching elements, and data for correcting the variation of the tuning frequency of the parallel tuning circuit is input to the control circuit from the outside. Therefore, the frequency can be corrected only by inputting the data.

Furthermore, according to the aspect of the invention, in the tuning frequency correction circuit, two transistors are differentially connected to each other. Therefore, it is possible to implement a balanced amplifying circuit or oscillating circuit without a variation in frequency.

Moreover, according to the aspect of the invention, in the tuning frequency correction circuit, the capacitive unit is provided with a varactor diode to which a tuning voltage is applied, and a tuning frequency by the parallel tuning circuit and the capacitance adding units is set to a predetermined value in a state where a predetermined voltage is applied to the varactor diode. Therefore, it is possible to widen the tuning frequency or the oscillating frequency to the maximum within a necessary frequency range.

In addition, according to the aspect of the invention, in the tuning frequency correction circuit, the parallel tuning circuit is connected to signal output terminals of the transistors. Therefore, it is possible to implement a mixing circuit without the variation of a tuning frequency.

Further, according to another aspect of the invention, a terrestrial digital broadcasting receiving tuner includes a variable tuning amplifying circuit composed of the amplifying transistors and the above-mentioned tuning frequency correction circuit, an oscillating circuit composed of the oscillating transistors and the above-mentioned tuning frequency correction circuit, and a mixing circuit composed of the mixing transistors and the above-mentioned tuning frequency correction circuit. Accordingly, it is possible to widen the range of a receiving frequency of a terrestrial digital broadcasting receiving tuner using a battery as a power source to the maximum.

## Claims

1. A tuning frequency correction circuit comprising:
a circuit board provided with an inductor composed of a printed conductor;
a capacitive unit provided on the circuit board and constituting a parallel tuning circuit together with the inductor; and
an integrated circuit which is provided with amplifying transistors, mixing transistors, or oscillating transistors connected to the parallel tuning circuit and which is mounted on the circuit board,
wherein the integrated circuit includes one or more capacitance adding units which are connected in parallel to the parallel tuning circuit, each capacitance adding unit being composed of a switching element and a capacitive element connected in series to the switching element, and
wherein a variation of a tuning frequency of the parallel tuning circuit is corrected by turning on or off the switching elements.

2. The tuning frequency correction circuit according to claim 1,
wherein the integrated circuit further includes a control circuit for controlling on or off states of the switching elements, and
wherein data for correcting the variation of the tuning frequency of the parallel tuning circuit is input to the control circuit from the outside.

3. The tuning frequency correction circuit according to claim 1 or 2,
wherein the two transistors are differentially connected to each other.

4. The tuning frequency correction circuit according to any one of claims 1 to 3,
wherein the capacitive unit is provided with a varactor diode to which a tuning voltage is applied, and
wherein a tuning frequency by the parallel tuning circuit and the capacitance adding units is set to a predetermined value in a state where a predetermined voltage is applied to the varactor diode.

5. The tuning frequency correction circuit according to any one of claims 1 to 3,
wherein the parallel tuning circuit is connected to signal output terminals of the transistors.

6. A terrestrial digital broadcasting receiving tuner comprising:
a variable tuning amplifying circuit composed of the amplifying transistors and the tuning frequency correction circuit according to claim 4;
an oscillating circuit composed of the oscillating transistors and the tuning frequency correction circuit according to claim 4; and
a mixing circuit composed of the mixing transistors and the tuning frequency correction circuit according to claim 5.
